# FASCICULE DE BREVET EUROPEEN

(11) **EP 0 380 624 B1**
(45) Date de publication et mention de la délivrance du brevet: **23.08.1995**
(21) Numéro de dépôt: 89908205.1
(22) Date de dépôt: 04.07.1989
(51) Int. Cl.: G11B 5/255

(54) **Tête magnétique d'enregistrement-lecture**
Magnetischer Wiedergabe-/Aufzeichnungskopf
Recording-reading magnetic head

(30) Priorité: 05.07.1988 FR 8809068
(43) Date de publication de la demande: 08.08.1990
(73) Titulaire: THOMSON-CSF, 75008 Paris (FR)
(72) Inventeur: MEUNIER, Paul-Louis, F-75012 Paris (FR); COUTELLIER, Jean-Marc, F-78310 Maurepas (FR); RAZEGHI, Manijeh, F-91190 Gif-sur-Yvette (FR); MACKOWSKI, Jean-Marie, F-69100 Villeurbanne (FR)
(74) Mandataire: Guérin, Michel
(86) Numéro de dépôt international: FR8900346
(87) Numéro de publication internationale: WO9000793

(56) Documents cités:
- EP-A- 0 123 826
- EP-A- 0 240 088
- EP-A- 0 241 371
- WO-A-88/06334
- FR-A- 2 474 219
- FR-A- 2 569 072
- US-A- 3 594 064
- US-A- 4 713 279
- PATENT ABSTRACTS OF JAPAN vol. 8, no. 257 (P-316)(1694) 24 novembre 1984, & JP-A-59 127232 (SUWA SEIKOSHA K.K.) 23 juillet 1984, voir le document en entier
- PATENT ABSTRACTS OF JAPAN vol. 9, no. 83 (P-348)(1806) 12 avril 1985, & JP-A-59213030 (DENKI KAGAKU KOGYO K.K.) 01 décembre 1984, voir le document en entier
- PATENT ABSTRACTS OF JAPAN vol. 5, no. 69 (P-60)(741) 09 mai 1981, & JP-A-5619517 (MATSUSHITA DENKI SANGYO K.K.) 24 février 1981, voir le document enentier
- PATENT ABSTRACTS OF JAPAN vol. 5, no. 69 (P-60)(741) 09 mai 1981, & JP-A-5619518 (MATSUSHITA DENKI SANGYO K.K.) 24 février 1981, voir le document en
- PATENT ABSTRACTS OF JAPAN vol. 10, no. 48 (P-431)(2105) 25 février 1986, & JP-A-60 193112 (SEIKO DENSHI KOGYO K.K.) 01 octobre 1985, voir le document enentier
- PATENT ABSTRACTS OF JAPAN vol. 13, no. 17 (P-813)(3365) 17 janvier 1989, & JP-A-63 222313 (TDK CORP) 16 septembre 1988, voir le document en entier

## Description

L'invention concerne une tête magnétique d'enregistrement-lecture.

Dans la technique des têtes magnétiques réalisées en couches minces, le problème de l'usure est crucial notamment pour les appareils d'enregistrement-lecture à bandes magnétiques.

Une tête type VHS s'use de 20 micromètres en 2000 heures d'utilisation de bande circulant à 5 mètres par seconde.

Pour protéger ces têtes, on peut déposer un revêtement très mince (quelques centaines d'Angstroems) de carbone, CSi, Zr par exemple.

Vu l'hétérogénéité des têtes ferrite - sendust ou permalloy - Al₂ O₃ - Verre, il est rare qu'un type de matériau accroche sur toute une surface pour les mêmes conditions de dépôt (plasma par exemple).

Il convient donc de protéger ces têtes magnétiques par une couche d'un matériau présentant une bonne résistance à l'usure.

Les documents EP-A-0241371 et JP 60 193 112 concernent des têtes dans lesquelles les pôles magnétiques à protéger sont perpendiculaires et non parallèles à la surface active de la tête sur laquelle vient frotter le support magnétique à lire ou à inscrire.

Cependant, l'invention concerne les protections d'une tête dans laquelle les pôles magnétiques sont parallèles à la surface active de la tête magnétique.

La Demande de Brevet WO 89/04039 décrit une tête magnétique dont les pôles magnétiques sont en couches minces de sendust (alliage d'aluminium, de fer et de silicium) et sont protégés par une couche de carbone. Cependant, la Demande de Brevet ne mentionne pas la présence d'une couche d'accrochage en oxyde de Silicium (SiO₂). Cette Demande de Brevet a été déposée sous priorité française le 27 Octobre 1987 et publiée le 5 Mai 1989 après la présente Demande de Brevet. Elle ne fait donc partie de l'état de la technique que pour estimer la nouveauté de la présente Demande de Brevet et cela pour les pays qui ont été désignés en commun dans la Demande de Brevet correspondant à WO 89/04039 et dans la présente Demande de Brevet.

Un matériau qui conviendrait parfaitement pour assurer cette protection contre l'usure est le carbone. Cependant, il a été constaté qu'une couche mince de carbone (250 Angstroems) adhère difficilement sur des matériaux type ferrite. Ceci a été prouvé en laboratoire, par des tests d'usure sur tête carbone.ferrite.

C'est pourquoi, l'invention fournit une solution permettant de résoudre ce problème.

L'invention concerne donc une tête magnétique d'enregistrement-lecture, comprenant deux couches minces en alliage de fer, d'aluminium et de silicium (Sendust) séparées par un entrefer en matériau amagnétique et situées à plat sur deux parties en ferrite séparées par du matériau isolant, lesdites couches constituant la partie essentielle active de la tête étant recouvertes d'une couche d'accrochage en oxyde de silicium elle-même recouverte d'une couche anti-usure à base de carbone.

Les différents objets et caractéristiques de l'invention apparaîtront de façon plus détaillée dans la description qui va suivre faite à titre d'exemple en se reportant aux figures annexées qui représentent
- la figure 1, un exemple de réalisation de la couche anti-usure et de la couche d'accrochage utilisées dans la tête magnétique de la figure 2 ;
- la figure 2, un exemple de réalisation d'une tête magnétique d'enregistrement-lecture selon l'invention.

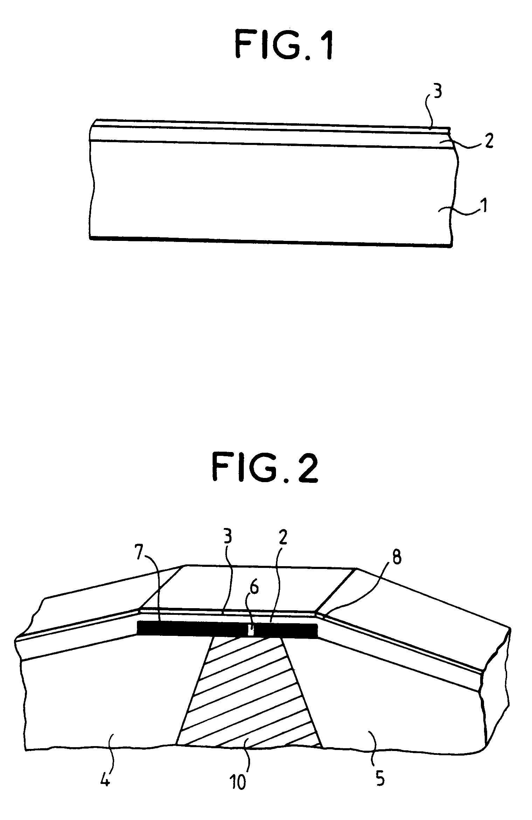

En se reportant à la figure 1, on va tout d'abord décrire un dispositif magnétique dans lequel le dispositif comporte au moins une couche 1 en matériau magnétique, telle que de la ferrite, que l'on veut protéger contre l'usure.

Il a été démontré en laboratoire que le carbone type adamentin accrochait parfaitement sur une surface en silice. Par ailleurs, la silice adhère parfaitement sur des matériaux type ferrite.

Le dispositif comporte donc sur la couche 1, une couche 2 en silice (SiO₂), laquelle est revêtue d'une couche 3 en carbone adamantin.

Il a été prouvé qu'un très léger dépôt de C ( 30 Å), c'est à dire un temps de dépôt de quelques secondes, est suffisant pour rendre la surface de silice très dure.

De façon plus générale, la couche 2 est à base d'un matériau qui accroche au substrat et plus particulièrement à base de silicium (sans être précisément de la silice ou du titane). De même, la couche 3 peut être un matériau à base de carbone.

Selon une variante de réalisation, les couches 2 et 3 peuvent être réalisées en une seule couche et leur composition, en silicium et en carbone, est choisie de façon d'une part à obtenir un bon accrochage sur la couche 1 et à fournir une bonne protection contre l'usure.

La couche 2 permet l'accrochage efficace sur les couches 7 et 8 (Sendust). Son épaisseur peut être de 100 à 200 Angstroems.

La couche 3 s'accroche bien sur la couche 2 et permet une protection efficace contre l'usure. Son épaisseur peut être de 20 à 50 Angstroems, par exemple, selon le temps d'utilisation que l'on désire obtenir.

La figure 2, représente un exemple d'une tête magnétique selon l'invention dans laquelle l'entrefer 6 de la tête est réalisé par les deux couches 7 et 8 de sendust situées à plat sur deux parties en ferrite 4 et 5 séparées par du matériau isolant 10 du type verre. Ces couches 7 et 8 constituent alors une partie essentielle de la surface active de la tête. La tête magnétique de la figure 2 comporte une couche d'accrochage 2 en oxyde de silicium (SiO₂) et une couche anti-usure 3 en carbone adamantin. Les épaisseurs de ces couches peuvent être celles indiquées ci-après.

Pour la réalisation de telles couches de protection, si l'on considère un dépôt de type plasma, les dispositifs à protéger telles que les têtes magnétiques sont dans la même enceinte et on dépose le silicium, par l'intermédiaire de gaz tel que le silane, ou la silice par silane et oxygène. On peut régler les conditions de dépôt pour obtenir un type donné de silice. Le dépôt peut atteindre une épaisseur de 200 Angstroems environ.

Ensuite sans détruire le vide, de l'enceinte, on dépose pendant un temps très court (quelques secondes) la couche de carbone adamentin.

Cette méthode s'applique aussi au Sputtering (pulvérisation cathodique), il suffit de disposer des cibles appropriées de silicium et de graphite. Ceci s'effectue dans la même étape de dépôt.

On peut aussi effectuer ce dépôt par tout autre dépôt d'épitaxie connu.

On peut aussi faire des mélange des deux composants (silicium et carbone) en utilisant le Dual Ion Beam Sputtering (une cible Si, une cible C).

## Revendications

1. Tête magnétique d'enregistrement-lecture, comprenant deux couches minces (7, 8) en alliage de fer, d'aluminium et de silicium (Sendust) séparées par un entrefer (6) en matériau amagnétique et situées à plat sur deux parties en ferrite (4, 5) séparées par du matériau isolant (10), lesdites couches constituant la partie essentielle active de la tête étant recouvertes d'une couche d'accrochage (2) en oxyde de silicium (SiO₂), elle-même recouverte d'une couche anti-usure (3) à base de carbone.

2. Tête magnétique selon la revendication 1, caractérisée en ce que la couche d'accrochage (2) a une épaisseur comprise entre 10 et 20 nm.

3. Tête magnétique selon la revendication 1, caractérisée en ce que la couche de protection (3) a une épaisseur comprise entre 2 et 5 nm.

## Patentansprüche

1. Magnetischer Schreib- und Lesekopf mit zwei dünnen Schichten (7, 8) aus einer Legierung von Eisen, Aluminium und Silizium (Sendust), die durch einen Magnetspalt (6) aus einem unmagnetischen Material voneinander getrennt sind und flach auf zwei Ferritbereichen (4, 5) aufliegen, die durch Isoliermaterial (10) voneinander getrennt sind, wobei die Schichten, die den wesentlichen aktiven Teil des Kopfes bilden, mit einer Haftschicht (2) aus Siliziumoxid (SiO₂) bedeckt sind, auf der ihrerseits eine abriebfeste Schicht (3) auf Kohlenstoffbasis liegt.

2. Magnetkopf nach Anspruch 1, dadurch gekennzeichnet, daß die Dicke der Haftschicht (2) zwischen 10 und 20 nm liegt.

3. Magnetkopf nach Anspruch 1, dadurch gekennzeichnet, daß die Dicke der Schutzschicht (3) zwischen 2 und 5 nm liegt.

## Claims

1. Magnetic record-replay head, comprising two thin layers (7, 8) made of iron, aluminium and silicon alloy (Sendust), separated by a gap (6) of non-magnetic material and situated flat on two parts made of ferrite (4, 5) which are separated by insulating material (10), the said layers constituting the essential active part of the head being covered with a bonding layer (2) of silicon oxide (SiO₂), which is itself covered by a carbon-based anti-wear layer (3).

2. Magnetic head according to Claim 1, characterized in that the bonding layer (2) has a thickness lying between 10 and 20 nm.

3. Magnetic head according to Claim 1, characterized in that the protective layer (3) has a thickness lying between 2 and 5 nm.
